# EUROPEAN PATENT SPECIFICATION

(11) **EP 0 980 075 B1**
(45) Date of publication and mention of the grant of the patent: **29.10.2008**
(21) Application number: 99305823.9
(22) Date of filing: 22.07.1999
(51) Int. Cl.: G11C 7/12, G11C 7/18

(54) **A semiconductor memory device**
Eine Halbleiterspeichervorrichtung
Une mémoire semi-conducteurs

(30) Priority: 13.08.1998 KR 3289098; 04.05.1999 KR 1600499
(43) Date of publication of application: 16.02.2000
(73) Proprietor: SAMSUNG ELECTRONICS CO., LTD., Suwon-City, Kyungki-do (KR)
(72) Inventor: Roh, Jae-gu, Suwon-city, Kyungki-do (KR)
(74) Representative: Ertl, Nicholas Justin

(56) References cited:
- US-A- 5 243 574
- US-A- 5 396 465
- PATENT ABSTRACTS OF JAPAN vol. 016, no. 341 (P-1391), 23 July 1992 (1992-07-23) & JP 04 102295 A (FUJITSU LTD), 3 April 1992 (1992-04-03)

## Description

The present invention relates to a semiconductor memory device, and more particularly, to a semiconductor memory device which can prevent the loss of speed due to the large load of an isolation control line for controlling isolation transistors.

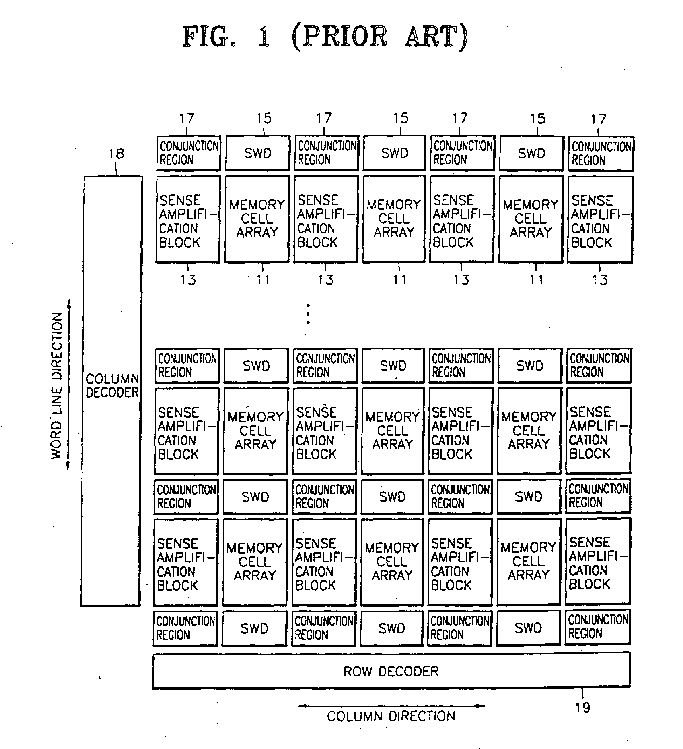

Semiconductor memory devices have been continuously developed to satisfy requirements for large capacity and high speed. This tendency is especially remarkable in the DRAM field in which a memory cell is formed out of a capacitor and an access transistor. In general, a large capacity semiconductor memory device, such as a synchronous DRAM and a double data rate (DDR) DRAM, has a structure in which the row decoder is vertically arranged as shown in FIG. 1. Namely, the length in the wordline direction is long, and a local input and output line LIO and a global input and output line GIO are used.

Referring to FIG. 1, a general large capacity semiconductor memory device includes a plurality of memory cell arrays 11 arranged in a matrix of rows and columns, a plurality of sense amplification blocks 13 arranged at either side of each memory cell array 11, a plurality of sub word line drivers (SWD) 15 arranged at the upper and lower ends of the memory cell arrays 11, a plurality of conjunction regions 17 arranged at the upper and lower ends of the sense amplification blocks 13, a column decoder 18 arranged on the left of the matrix of the plurality of memory cell arrays 11, and a row decoder 19 arranged at the lower end of the matrix of the plurality of memory cell arrays 11.

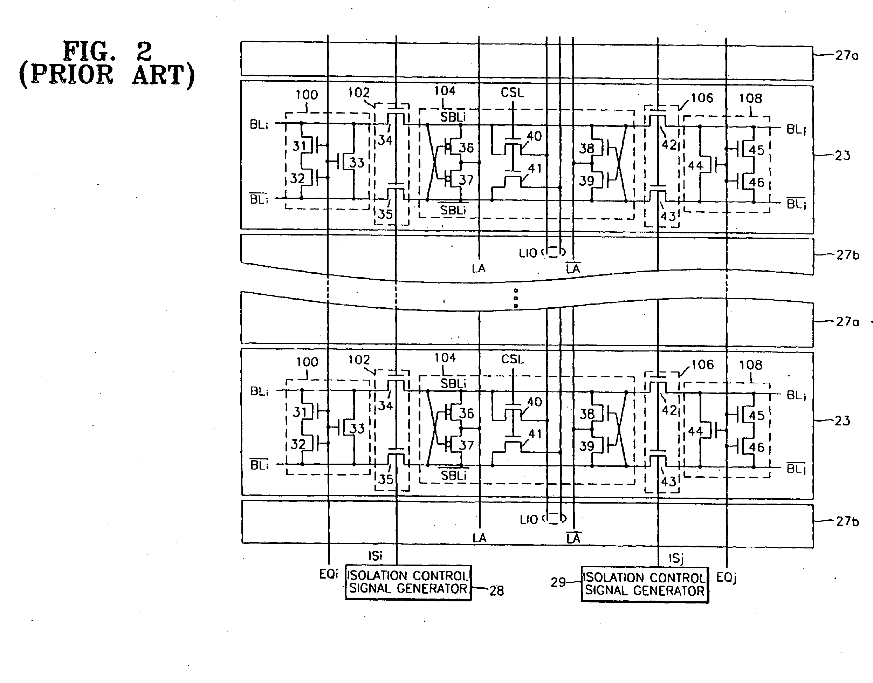

FIG. 2 is a circuit diagram of sense amplification blocks and conjunction regions of the semiconductor memory device shown in FIG. 1 according to a conventional technology. The conjunction regions 27a and 27b are arranged at the upper and lower ends of the sense amplification blocks 23. Each sense amplification block 23 has a general folded bit line-shared sense amplifier structure. The sense amplification block 23 includes: a) a first switching unit 102 for connecting a first pair of bit lines BLi and *B̅L̅i̅* to a pair of sensing bit lines SBLi and *S̅B̅L̅i̅* in response to a first isolation control signal transmitted through a first isolation control line ISi; b) a first equalizer 100 connected between the first pair of bit lines BLi and *B̅L̅i̅* for equalizing the first pair of bit lines Bli and *B̅L̅i̅* in response to a first equalizing signal transmitted through a first equalization control line EQi; c) a second switching unit 106 for connecting a second pair of bit lines BLj and *B̅L̅j̅* to the pair of sensing bit lines SBLi and *S̅B̅L̅i̅* in response to a second isolation control signal transmitted through a second isolation control line ISj; and d) a second equalizer 108 connected between the second pair of bit lines BLj and *B̅L̅j̅* for equalizing the second pair of bit lines BLj and *B̅L̅i̅* in response to a second equalizing signal transmitted through a second equalizing control line EQj, and a sense amplifier 104 for sensing the voltage difference between the pair of sensing bit lines SBLi and *S̅B̅L̅i̅* and amplifying the voltage difference.

Though not shown here, a memory cell array (i) is connected to the first pair of bit lines BLi and *B̅L̅i̅* and a memory cell array (j) is connected to the second pair of bit lines BLj and *B̅L̅j̅ .*

The conjunction regions 27a and 27b include LA and *L̅A̅* drivers (not shown) for respectively enabling the P-type and N-type sense amplifiers of the sense amplifier 104, a transfer transistor (not shown) for connecting a local input and output line LIO connected to the sense amplifier 104 to a global input and output line GIO (not shown), and a control circuit (not shown) for controlling the sub word line drivers.

The first isolation control signal, applied to the gates of isolation transistors 34 and 35 of the first switching unit 102, and the second isolation control signal, applied to the gates of the isolation transistors 42 and 43 of the second switching unit 106, are generated from peripheral circuits connected to the first isolation control line ISi and the second isolation control line ISj, i.e., isolation control signal generators 28 and 29.

In a semiconductor memory device having a structure in which the row decoder is vertically arranged, i.e., a structure in which the length in the wordline direction is long and the local and global input and output lines are used, the length of the first and second isolation control lines ISi and ISj become longer than those of a structure in which the row decoder is horizontally arranged. Accordingly, the load of the first isolation control line ISi and the second isolation control line ISj, i.e., a parasitic capacitance, increases to no less than two times the load.

When the memory cell array (i) connected to the first pair of bit lines BLi and *̅B̅L̅i̅*̅ is activated and operates, the voltage of first isolation control signal transmitted through the first isolation control line ISi is at a boosted voltage level VPP. The voltage of the second isolation control signal transmitted through the second isolation control line ISj is at the ground voltage level VSS. This is for reducing the load of the sense amplifier 104 by disconnecting the second pair of bit lines BLj and *B̅L̅j̅* from the pair of sensing bit lines SBLi and *S̅B̅L̅i̅* by turning off the second switching unit 106.

When the load of the second isolation control line ISj is large, the discharging speed of the second isolation control line ISj is lowered. Accordingly, the point of time at which the second isolation control signal becomes grounded at voltage VSS may be delayed. In this case, the load of the sense amplifier 104 becomes larger since the second switching unit 106 is not turned off during the sensing operation, namely, the second pair of bit lines BLj and *B̅L̅j̅* are not separated from the pair of sensing bit lines SBLi and *S̅B̅L̅i̅*.

Accordingly, the charge sharing time between the first pair of bit lines BLi and *̅B̅L̅i̅*̅ and the pair of sensing bit lines SBLi and *S̅B̅L̅i̅* increases. As a result, the operation of the sense amplifier 104 is delayed.

Therefore, the sizes of the driver ports of the isolation control signal generators 28 and 29 connected to the first isolation control line ISi and the second isolation control line ISj are made as large as possible in the conventional device in order to overcome the large load of the first isolation control line ISi and the second isolation control line ISj.

Since the driving ability of the driver ports is saturated of a certain point, even if the sizes of the driver ports are made as large as possible, it is not possible to overcome the doubled load.

The present invention provides a semi-conductor memory device according to claim 1, claim 5 and claim 12.

US 5,243,574 describes a semiconductor memory with two memory cell arrays, and shared sense amplifies between them. A sense amplifier activation signal selects one of the memory cell arrays.

In the present invention, it is possible to prevent the loss of speed due to the large load of the isolation control line by increasing the discharging speed of the isolation control line. This is done by a discharging means during the discharge of the isolation control line corresponding to the memory cell array which is not activated, even when the load of the isolation control line is large. Therefore, high speed operation can be performed.

Examples of the present invention will now be described in detail with reference to the accompanying drawings, in which:
FIG. 1 shows the structure of a known large capacity semiconductor memory device;
FIG. 2 is a circuit diagram of sense amplification blocks and conjunction regions of the semiconductor memory device shown in FIG. 1;
FIG. 3 is a circuit diagram of the sense amplification blocks and conjunction regions of the semiconductor memory device according to a first embodiment of the present invention; and,
FIG. 4 is a circuit diagram of the sense amplification blocks and conjunction regions of the semiconductor memory device according to the second embodiment of the present invention.

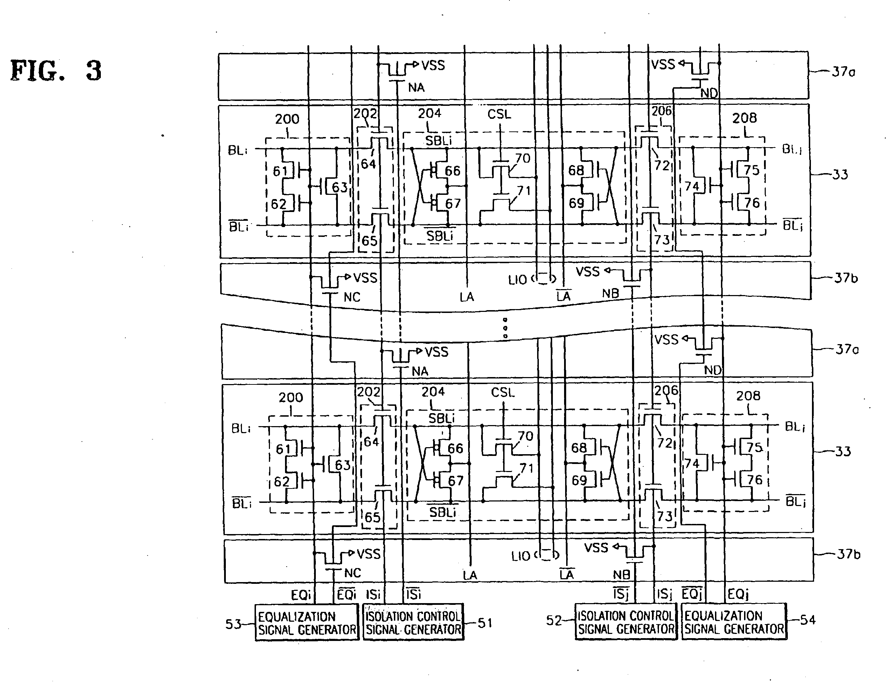

Referring to FIG. 3, the semiconductor memory device includes a plurality of sense amplification blocks 33 and a plurality of conjunction regions 37a and 37b arranged at the upper and lower ends of the sense amplification blocks 33 in the wordline direction.

Also, though not shown here, a memory cell array (i) connected to the first pair of bit lines BLi and *B̅L̅i̅* is arranged on the left side of the sense amplification block 33.

A memory cell array (j) connected to the second pair of bit lines BLj and *B̅L̅j̅* is arranged on the right side of the sense amplification block 33. Namely, the memory cell array (i) is arranged on the left side of the sense amplification block 33 and the memory cell array (j) is arranged on the right side of the sense amplification block 33, in the column direction.

The conjunction regions 37a include a discharging unit NA connected between a first isolation control line ISi and the ground VSS, the discharging unit NA controlled by a signal transmitted through the complementary line *I̅S̅i̅* of the first isolation control line ISi, i.e., the inverted signal of a first isolation control signal, and a discharging unit ND connected between a second equalization control line EQj and the ground VSS, the discharging unit ND controlled by a signal transmitted through the complementary line *E̅Q̅j̅* of the second equalization control line EQj, i.e., the inverted signal of a second equalization signal. Here, the discharging unit NA is comprised of an NMOS transistor the drain of which is connected to the first isolation control line ISi, the gate of which is connected to the complementary line *I̅S̅i̅* of the first isolation control line, and the source of which is connected to the ground VSS. The discharging unit ND is comprised of an NMOS transistor the drain of which is connected to the second equalization control line EQj, the gate of which is connected to the complementary line *E̅Q̅j̅* of the second equalization control line, and the source of which is connected to VSS.

The conjunction regions 37b include a discharging unit NB connected between a second isolation control line ISj and the ground VSS, the discharging unit NB controlled by a signal transmitted through the complementary line *I̅S̅j̅* of the second isolation control line ISj, i.e., the inverted signal of a second isolation control signal, and a discharging unit NC connected between a first equalization control line EQi and the ground VSS, the discharging unit NC controlled by a signal transmitted through the complementary line *E̅Q̅i̅* of the first equalization control line EQi, i.e., the inverted signal of a first equalization signal. Here, the discharging unit NB is comprised of an NMOS transistor the drain of which is connected to the second isolation control line ISj, the gate of which is connected to the complementary line *I̅S̅j̅* of the second isolation control line, and the source of which is connected to the ground VSS. The discharging unit NC is comprised of an NMOS transistor the drain of which is connected to the first equalization control line EQi, the gate of which is connected to the complementary line *E̅Q̅i̅* of the first equalization control line, and the source of which is connected to VSS.

The sense amplification blocks 33 have a folded bit line shared sense amplifier structure. The sense amplification blocks 33 include a pair of sensing bit lines SBLi and *S̅B̅L̅i̅,* a first equalizer 200, a first switching unit 202, a sense amplifier 204, a second switching unit 206, and a second equalizer 208.

The first equalizer 200 includes three NMOS transistors 61, 62, and 63 connected between the first pair of bit lines BLi and *B̅L̅i̅,* the gates of which are connected to a first equalization control line EQi, and equalizes the first pair of bit lines BLi and *B̅L̅i̅* in response to the first equalization signal transmitted through the first equalization control line EQi. The first switching unit 202 includes two NMOS isolation transistors 64 and 65, the sources and drains of which are respectively connected between the first pair of bit lines BLi and *B̅L̅i̅* and the pair of sensing bit lines SBLi and *S̅B̅L̅i̅,* and the gates of which are connected to the first isolation control line ISi. Thus, the switching unit connects the first pair of bit lines BLi and *B̅L̅i̅* to the pair of sensing bit lines SBLi and *S̅B̅L̅i̅* in response to the first isolation control signal transmitted through the first isolation control line ISi.

The second equalizer 208 includes three NMOS transistors 74, 75, and 76 connected between the second pair of bit lines BLj and *B̅L̅j̅,* and the gates of which are connected to a second equalization control line EQj, and equalizes the second pair of bit lines BLj and *B̅L̅j̅*. The second switching unit 206 includes two NMOS isolation transistors 72 and 73, the sources and drains of which are respectively connected between the second pair of bit lines BLj and *B̅L̅j̅* and the pair of sensing bit lines SBLi and *S̅B̅L̅i̅,* the gates of which are connected to a second isolation control line ISj. Thus the second switching unit 206 connects the second pair of bit lines BLj and *BLj* to the pair of sensing bit lines SBLi and *S̅B̅L̅i̅* in response to a second isolation control signal transmitted through the second isolation control line ISj.

The sense amplifier 204 includes a P-type sense amplifier comprised of PMOS transistors 66 and 67 and an N-type sense amplifier comprised of NMOS transistors 68 and 69, connected between the pair of sensing bit lines SBLi and *S̅B̅L̅i̅ .* The sense amplifier 204 senses and amplifies a voltage difference between the pair of sensing bit lines SBLi and *S̅B̅L̅i̅* during the sensing operation.

The voltage of the pair of sensing bit lines SBLi and *S̅B̅L̅i̅,* sensed and amplified by the sense amplifier 204. is transferred to the local input and output lines LIO through column selection gates 70 and 71 which are controlled by a column select line CSL. The column select line CSL is activated or deactivated by a column decoder (not shown) for decoding a column address signal.

Also, though not shown, the respective conjunction regions 37a and 37b include an LA driver (not shown) connected to a common connection line LA of the PMOS transistors 66 and 67 of the P-type sense amplifier and driven by a P-type sense amplifier control signal. They also include an *L̅A̅* driver (not shown) connected to a common connection line *L̅A̅* of the NMOS transistors 68 and 69 of the N-type sense amplifier and driven by an N-type sense amplifier control signal, a transfer transistor (not shown) for connecting the pair of local input and output lines LIO and the pair of global input and output lines GIO (not shown), and a control circuit (not shown) for controlling the sub word line driver.

The first isolation control signal and the inverted signal thereof are generated and output from an isolation control signal generator 51 connected to the first isolation control line ISi and the complementary line *I̅S̅i̅* of the first isolation control line.

The second isolation control signal and the inverted signal thereof are generated and output from the isolation control signal generator 52 connected to the second isolation control line ISj and the complementary line *I̅S̅j̅* of the second isolation control line.

Also, the first equalization signal and the inverted signal thereof are generated and output from an equalization signal generator 53 connected to the first equalization control line EQi and the complementary line *E̅Q̅i̅* of the first equalization control line. The second equalization signal and the inverted signal thereof are generated and output from an equalization signal generator 54 connected to the second equalization control line EQj and the complementary line *E̅Q̅j̅* of the second equalization control line.

The operation of the semiconductor memory device according to the above-mentioned present invention will now be described.

The NMOS isolation transistors 64 and 65 of the first switching unit 202 control the operation of the left memory cell array (i) connected to the first pair of bitlines BLi and *B̅L̅i̅ .* The NMOS isolation transistors 72 and 73 of the second switching unit 206 control the operation of the right memory cell array (j) connected to the second pair of bitlines BLj and *B̅L̅j̅*.

When the memory cell array (i) connected to the first pair of bitlines BLi and *̅B̅L̅i̅*̅ is activated and operates, the first isolation control signal transmitted through the first isolation control line ISi is at a boosted voltage level VPP. The second isolation control signal transmitted through the second isolation control line ISj is discharged into the ground voltage level VSS. This is for reducing the load to the sense amplifier 204 during the sensing operation by separating the pair of sensing bitlines SBLi and *S̅B̅L̅i̅* from the second pair of bitlines BLi and *B̅L̅i̅* by turning off the second switching unit 206.

In particular, in the semiconductor memory device of the present invention, the second isolation control signal is quickly discharged into the ground voltage level VSS by turning on the second discharging unit NB to which the inverted signal of the second isolation control signal is applied, though the load of the second isolation control line ISj is large while the second isolation control signal is discharged into the ground voltage level VSS. Namely, the discharge speed of the second isolation control line ISj increases by the second discharging unit NB.

Accordingly, the NMOS isolation transistors 64 and 65 of the first switching unit 202 are turned on and the NMOS isolation transistors 72 and 73 of the second switching unit 206 are quickly turned off. Namely, the second pair of bitlines BLj and *̅B̅L̅j̅*̅ are separated from the pair of sensing bitlines SBLi and *S̅B̅L̅i̅* during the sensing operation and the load to the sense amplifier 204 is reduced. Accordingly, the charge sharing time between the first pair of bitlines BLi and *B̅L̅i̅* and the pair of sensing bitlines SBLi and *S̅B̅L̅i̅* is reduced. As a result, the operation of the sense amplifier 204 becomes quicker.

Also, when the memory cell array (i) is activated and operates, the first equalization signal transmitted through the first equalization control line EQi should be quickly discharged to the ground voltage level VSS. Namely, the first equalizer 200 should be quickly turned off. To achieve this, in the semiconductor memory device according to the first embodiment of the present invention, the first equalization signal is quickly discharged to the ground voltage level VSS by turning on the discharging unit NC to which the inverted signal of the first equalization signal is applied, even though the load of the first equalization control line EQi is large.

In the semiconductor memory device according to the first embodiment of the present invention, the size of the layout is increased since the complementary line *I̅S̅i̅* of the first isolation control line, the complementary line *I̅S̅j̅* of the second isolation control line, the complementary line *E̅Q̅i̅* of the first equalization control line, and the complementary line *E̅Q̅j̅* of the second equalization control line should be further arranged in the sense amplification blocks and conjunction regions.

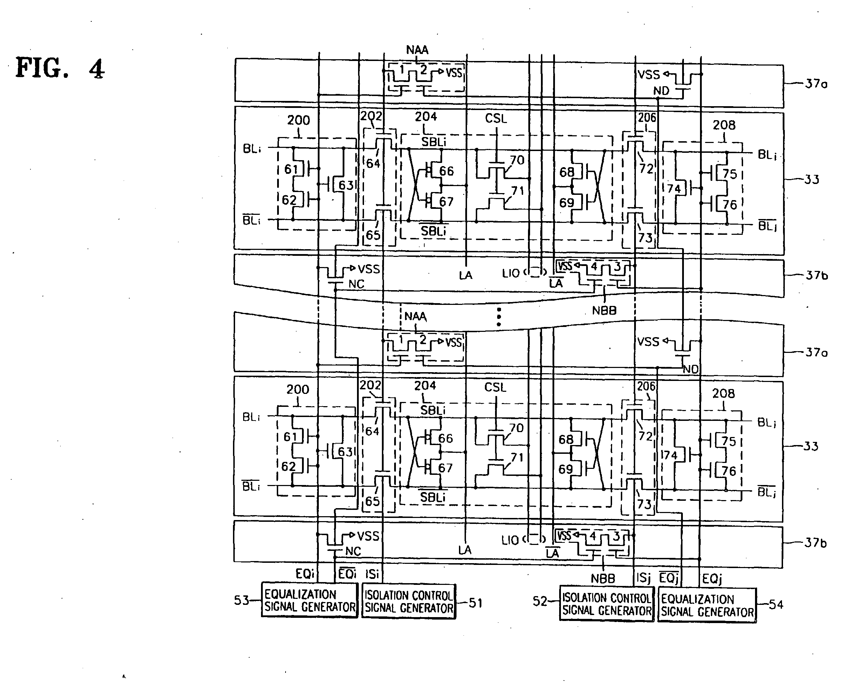

FIG. 4 is a circuit diagram of the sense amplification blocks and conjunction regions of a semiconductor memory device according to a second embodiment of the present invention.

Referring to FIG. 4, in the semiconductor memory device according to the second embodiment of the present invention, a discharging unit NAA connected between the first isolation control line ISi and the ground VSS includes two NMOS transistors 1 and 2. A discharging unit NBB connected between the second isolation control line ISj and the ground VSS includes two NMOS transistors 3 and 4. The complementary line *I̅S̅i̅* of the first isolation control line and the complementary line *I̅S̅j̅* of the second isolation control line in the first embodiment shown in FIG. 3 are removed. Other members are the same as those of the semiconductor memory device described above.

More specifically, the discharging unit NAA includes an NMOS transistor I, the drain of which is connected to the first isolation control line ISi and the gate of which is connected to the first equalization control line EQi, and an NMOS transistor 2, the drain of which is connected to the source of the NMOS transistor 1, the gate of which is connected to the complementary line *E̅Q̅j̅* of the second equalization line, and the source of which is connected to the ground VSS. The discharging unit NBB includes an NMOS transistor 3, the drain of which is connected to the second isolation control line ISj and the gate of which is connected to the second equalization control line EQj and an NMOS transistor 4 the drain of which is connected to the source of the NMOS transistor 3, the gate of which is connected to the complementary line *E̅Q̅i̅* of the first equalization control line, and the source of which is connected to the ground VSS.

The reason why the discharging unit NAA is designed to be simultaneously controlled by the first equalization signal and the inverted signal of the second equalization signal, and the discharging unit NBB is designed to be simultaneously controlled by the second equalization signal and the inverted signal of the first equalization signal is as follows. The first and second equalization signals are all logic "high" in a precharge state. At this time, the first isolation control line ISi and the second isolation control line ISj should be precharged to logic "high", i.e., a supply voltage VDD level. If the discharging unit NAA is designed to be controlled by only the first equalization signal, the discharging unit NAA is turned on when the first equalization signal is activated to logic "high". Accordingly, the first isolation control line ISi becomes logic "low". If the discharging unit NBB is designed to be controlled by only the second equalization signal, the discharging unit NBB is turned on by the second equalization signal of logic "high". Accordingly, the second isolation control line ISj becomes logic "low". Therefore, the above is why the semiconductor memory device mis-operates.

The operation of the semiconductor memory device according to the second embodiment of the present invention will now be described.

When the memory cell array (i) connected to the first pair of bitlines BLi and *̅B̅L̅i̅*̅ is activated and operates, the first isolation control signal transmitted through the first isolation control line ISi is at a boosted voltage VPP level. The second isolation control signal transmitted through the second isolation control line ISj is discharged to the ground voltage level VSS. Also, the first equalization signal transmitted through the first equalization control line *EQi* is at the ground voltage level VSS. The second equalization signal transmitted through the second equalization control line EQj is at the supply voltage VDD level. Also, the inverted signal of the first equalization signal transmitted through the complementary line *E̅Q̅i̅* of the first equalization control line is at the supply voltage VDD level, and the inverted signal of the second equalization signal transmitted through the complementary line *E̅Q̅j̅* of the second equalization control line is at the ground voltage level VSS.

Accordingly, when the second isolation control signal is discharged to the ground voltage level VSS, the NMOS transistor 3 of the discharging unit NBB is turned on by the second equalization signal. Also, the NMOS transistor 4 of the discharging unit NBB is turned on by the inverted signal of the first equalization signal. As a result, the second isolation control signal transmitted through the second isolation control line ISj is quickly discharged into the ground voltage level VSS. At this time, the NMOS transistor 1 of the discharging unit NAA is turned off by the first equalization signal. The NMOS transistor 2 is turned off by the inverted signal of the second equalization signal.

Therefore, in this example, the NMOS isolation transistors 64 and 65 of the first switching unit 202 are turned on, and at the same time, the NMOS isolation transistors 72 and 73 of the second switching unit 206 are quickly turned off. Namely, since the second pair of bitlines BLj and *B̅L̅j̅* are separated from the pair of sensing bitlines SBLi and *S̅B̅L̅i̅* during a sensing operation, the load to the sense amplifier 204 is reduced. Accordingly, the charge sharing time between the pair of first bitlines BLi and *B̅L̅i̅* and the pair of sensing bitlines SBLi and *S̅B̅L̅i̅* is reduced. As a result, the operation of the sense amplifier 204 becomes faster.

In particular, in the semiconductor memory device according to the second embodiment of the present invention, the size of the layout is reduced since the complementary line *I̅S̅i̅* of the first isolation control line and the complementary line *I̅S̅j̅* of the second isolation control line are removed from the sense amplification blocks and conjunction regions.

In the semiconductor memory device of the present invention, the discharging speed of the first isolation control line ISi and the second isolation control line ISj becomes higher by the discharging units NA, NB, NAA, and NBB, even when the load of the first isolation control line ISi and the second isolation control line ISj more than doubles, as in the semiconductor memory device having the structure in which the row decoder is vertically arranged as shown in FIG. 1. Accordingly, since the sense amplifier 204 can quickly start the sense amplifying operation, the loss of speed is prevented.

As mentioned above, in the semiconductor memory device of the present invention, it is possible to prevent loss of speed due to the large load of the isolation control line. Therefore, faster operation can be performed.

## Claims

1. A semiconductor memory device, comprising:
a pair of bitlines (BLi, *B̅L̅i̅* )*;*
a memory cell array connected to the pair of bitlines;
a pair of sensing bitlines (SBLi, *S̅B̅L̅i̅*);
an isolation control signal generator (S1) arranged to generate an isolation control signal on an isolation control line (ISi);
a switching unit (202) for connecting the pair of bitlines (BLi, *B̅L̅i̅* ) and the pair of sensing bitlines (SBLi, *S̅B̅L̅i̅*) in response to the isolation control signal transmitted through the isolation control line (ISi); an equalizer (200) for equalizing the pair of bitlines in response to an equalization signal (EQi) transmitted through an equalization control line; and
a sense amplifier (204) for sensing and amplifying the voltage difference between the pair of sensing bitlines (SBLi, *S̅B̅L̅i̅*)*;*
**characterised by** a first discharge means (NA) connected between the isolation control line (ISi):and ground to discharge the isolation control line,
wherein the isolation control signal generator is arranged to generate an inverted isolation control signal on a complementary line *(I̅S̅i̅*) and the first discharge means (NA) is controlled by the inverted isolation control signal transmitted through the complementary line (*I̅S̅i̅*) of the isolation control line.

2. A semiconductor memory device according to claim 1, wherein the first discharge means (NA) is an NMOS transistor having a drain connected to the isolation control line (ISi), a gate connected to the complementary line of the isolation control line (*I̅S̅i̅)*, and a source connected to ground.

3. A semiconductor memory device according to claim 1 or 2, further comprising second discharge means (NC) connected between the equalization control line (EQi) and the ground to more quickly discharge the equalization control line.

4. A semiconductor memory device according to claim 3, wherein the second discharge means is an NMOS transistor having a drain connected to the equalization control line, a gate connected to the complementary line of the equalization control line, and a source connected to ground.

5. A semiconductor memory device comprising:
a first and a second pair of bitlines (BLi, *B̅L̅i̅ ,* BLj, *B̅L̅j̅*);
a first memory cell array connected to the first pair of bitlines (BLi, *B̅L̅i̅*)*;*
a second memory cell array connected to the second pair of bitlines (BLj, *B̅L̅j̅*)*;*
a pair of sensing bitlines (SBLi, *S̅B̅L̅i̅*)*;*
a first switching unit (202) for connecting the first pair of bitlines (BLi, *B̅L̅i̅*) and the pair of sensing bitlines (SBLi, *S̅B̅L̅i̅*) in response to a first isolation control signal transmitted through a first isolation control line (ISi);
a first isolation control signal generator (51) for generating said first isolation control signal (ISi);
a second isolation control signal generator (52) for generating a second isolation control signal (ISj);
a second switching unit (206) for connecting the second pair of bitlines (BLj, *B̅L̅j̅*) to the pair of sensing bitlines in response to said second isolation control signal transmitted through a second isolation control line (ISj);
a first equalizer (200) for equalizing the first pair of bitlines in response to a first equalization signal transmitted through a first equalization control line;
a second equalizer (208) for equalizing the second pair of bitlines in response to a second equalization signal transmitted through a second equalization control line;
a sense amplifier (204) for sensing and amplifying the voltage difference between the pair of sensing bitlines;
first discharge means (NA) connected between the first isolation control line and ground to discharge the first isolation control line during the activation of the second memory cell array; and
second discharge means (NB) connected between the second isolation control line and ground to discharge the second isolation control line during the activation of the first memory cell array.

6. A semiconductor memory device according to claim 5, wherein the first discharge means (NA) is an NMOS transistor, a drain connected to the first isolation control line, a gate connected to the complementary line of the first isolation control line, and the source of which is connected to ground;
wherein the first discharge means comprises:
a first NMOS transistor having a drain connected to the first isolation control line, and a gate connected to the first equalization control line: and
a second NMOS transistor having a drain connected to the source of the first NMOS transistor, a gate connected to the complementary line of the second equalization control line, and a source connected to ground.

7. A semiconductor memory device according to claim 5, wherein the second discharge means (NB) is an NMOS transistor, a drain connected to the second isolation control line, a gate connected to the complementary line of the second isolation control line, and a source connected to ground.

8. A semiconductor memory device according to claim 5, wherein the second discharge means (NB) comprises:
a first NMOS transistor having a drain connected to the second isolation control line, and a gate connected to the second equalization control line: and
a second NMOS transistor having a drain connected to the source of the first NMOS transistor, a gate connected to the complementary line of the first equalization control line, and a source connected to ground.

9. A semiconductor memory device according to any of claims 5 to 8, further comprising:
third discharge means (NC) connected between the first equalization control line and
ground to more quickly discharge the first equalization control line; and
fourth discharge means (ND) connected between the second equalization control line and ground to more quickly discharge the second equalization control line.

10. A semiconductor memory device according to claim 9, wherein the third discharge means (NC) is an NMOS transistor having a drain connected to the first equalization control line, a gate connected to the complementary line of the first equalization control line, and a source connected to ground.

11. A semiconductor memory device according to claim 9 or 10, wherein the fourth discharge means (ND) is an NMOS transistor having a drain connected to the second equalization control line, a gate connected to the complementary line of the second equalization control line, and a source connected to ground.

12. A semiconductor memory device, comprising:
a plurality of memory cell arrays each having a pair of bitlines (BLi, *B̅L̅i̅,* BLj, *B̅L̅j̅*) and a plurality of memory cells connected to the pair of bitlines;
an isolation control signal generator (51) arranged to generate an isolation control signal on an isolation control line;
a plurality of sense amplification blocks (33) arranged on the left and right sides of the respective memory cell arrays in a column direction, each having a pair of sensing bitlines (SBLi, *S̅B̅L̅i̅*)*,* a switching unit for connecting the pair of bitlines to the pair of sensing bitlines in response to said isolation control signal transmitted through said isolation control line, an equalizer (200, 208) for equalizing the pair of bitlines in response to an equalization signal transmitted through an equalization control line, and a sense amplifier (204) for sensing and amplifying the voltage difference between the pair of sensing bitlines; and
a plurality of conjunction regions (27a, 27b) arranged at the upper and lower ends of the sense amplification blocks (23) in a wordline direction;
**characterised by** first discharge means (NA) connected between the isolation control line and ground to more quickly discharge the isolation control line included in the respective conjunction regions, wherein the first discharge means is controlled by the inverted isolation control signal transmitted through the complementary line of the isolation control line.

13. A semiconductor memory device according to claim 12, wherein the first discharge means (NA) is an NMOS transistor having a drain connected to the isolation control line, a gate connected to the complementary line of the isolation control line, and a source connected to ground.

14. A semiconductor memory device according to claim 12 or 13, further comprising second discharge means (NB) connected between the equalization control line and ground to more quickly discharge the equalization control line in each conjunction region.

15. A semiconductor memory device according to claim 14, wherein the second discharge means (NB) is an NMOS transistor having a drain connected to the equalization control line, a gate connected to the complementary line of the equalization control line, and a source connected to ground.

## Patentansprüche

1. Halbleiterspeicherbauelement, das Folgendes umfasst:
ein Paar Bitleitungen (BLi, *B̅L̅i̅);*
ein mit dem Bitleitungspaar verbundenes Speicherzellenarray;
ein Paar Lesebitleitungen (SBLi, *S̅B̅L̅i̅)*;
einen Isolationssteuersignalgenerator (51) zum Erzeugen eines Isolationssteuersignals auf einer Isolationssteuerleitung (ISi);
eine Schalteinheit (202) zum Verbinden des Bitleitungspaares (BLi, *B̅L̅i̅)* und des Lesebitleitungspaares (SBLi, *S̅B̅L̅i̅)* als Reaktion auf das über die Isolationssteuerleitung (ISi) gesendete Isolationssteuersignal; einen Entzerrer (200) zum Entzerren des Bitleitungspaares als Reaktion auf ein über eine Entzerrungssteuerleitung gesendetes Entzerrungssignal (EQi); und
einen Leseverstärker (204) zum Erfassen und Verstärken der Spannungsdifferenz zwischen dem Paar Lesebitleitungen (SBLi, *S̅B̅L̅i̅*) ;
**gekennzeichnet durch** ein erstes Entlademittel (NA), das zwischen der Isolationssteuerleitung (ISi) und Masse geschaltet ist, um die Isolationssteuerleitung zu entladen,
wobei der Isolationssteuersignalgenerator die Aufgabe hat, ein invertiertes Isolationssteuersignal auf einer komplementären Leitung (*I̅S̅i̅*) zu erzeugen, und das erste Entlademittel (NA) von dem über die komplementäre Leitung (*I̅S̅i̅*) der Isolationssteuerleitung gesendeten invertierten Isolationssteuersignal gesteuert wird.

2. Halbleiterspeicherbauelement nach Anspruch 1, wobei das erste Entlademittel (NA) ein NMOS-Transistor mit einem mit der Isolationssteuerleitung (ISi) verbundenen Drain, einem mit der komplementären Leitung der Isolationssteuerleitung (*I̅S̅i̅*) verbundenen Gate und einer mit Masse verbundenen Source ist.

3. Halbleiterspeicherbauelement nach Anspruch 1 oder 2, das ferner ein zweites Entlademittel (NC) umfasst, das zwischen der Entzerrungssteuerleitung (EQi) und Masse geschaltet ist, um die Entzerrungssteuerleitung schneller zu entladen.

4. Halbleiterspeicherbauelement nach Anspruch 3, wobei das zweite Entlademittel ein NMOS-Transistor mit einem mit der Entzerrungssteuerleitung verbundenen Drain, einem mit der komplementären Leitung der Entzerrungssteuerleitung verbundenen Gate und einer mit Masse verbundenen Source ist.

5. Halbleiterspeicherbauelement, das Folgendes umfasst:
ein erstes und ein zweites Bitleitungspaar (BLi, *B̅L̅i̅,* BLj, *B̅L̅j̅* );
ein mit dem ersten Bitleitungspaar (BLi, *B̅L̅i̅)* verbundenes erstes Speicherzellenarray;
ein mit dem zweiten Bitleitungspaar (BLj, *B̅L̅j̅)* verbundenes zweites Speicherzellenarray;
ein Paar Lesebitleitungen (SBLi, *S̅B̅L̅i̅);*
eine erste Schalteinheit (202) zum Verbinden des ersten Bitleitungspaares (BLi, *B̅L̅i̅)* und des Lesebitleitungspaares (SBLi, *S̅B̅L̅i̅)* als Reaktion auf ein über eine erste Isolationssteuerleitung (ISi) gesendetes erstes Isolationssteuersignal;
einen ersten Isolationssteuersignalgenerator (51) zum Erzeugen des genannten ersten Isolationssteuersignals (ISi) ;
einen zweiten Isolationssteuersignalgenerator (52) zum Erzeugen eines zweiten Isolationssteuersignals (ISj);
eine zweite Schalteinheit (206) zum Verbinden des zweiten Bitleitungspaares (BLj, *B̅L̅j̅)* mit dem Paar Lesebitleitungen als Reaktion auf das genannte, über eine zweite Isolationssteuerleitung (ISj) gesendete zweite Isolationssteuersignal;
einen ersten Entzerrer (200) zum Entzerren des ersten Bitleitungspaares als Reaktion auf ein über eine erste Entzerrungssteuerleitung gesendetes Entzerrungssignal;
einen zweiten Entzerrer (208) zum Entzerren des zweiten Bitleitungspaares als Reaktion auf ein über eine zweite Entzerrungssteuerleitung gesendetes zweites Entzerrungssignal;
einen Leseverstärker (204) zum Erfassen und Verstärken der Spannungsdifferenz zwischen dem Paar Lesebitleitungen;
ein erstes Entlademittel (NA), das zwischen der ersten Isolationssteuerleitung und Masse geschaltet ist, um die erste Isolationssteuerleitung bei der Aktivierung des zweiten Speicherzellenarrays zu entladen; und
ein zweites Entlademittel (NB), das zwischen der zweiten Isolationssteuerleitung und Masse geschaltet ist, um die zweite Isolationssteuerleitung bei der Aktivierung des ersten Speicherzellenarrays zu entladen.

6. Halbleiterspeicherbauelement nach Anspruch 5, wobei das erste Entlademittel (NA) ein NMOS-Transistor mit einem mit der ersten Isolationssteuerleitung verbundenen Drain, einem mit der komplementären Leitung der ersten Isolationssteuerleitung verbundenen Gate und einer mit Masse verbundenen Source ist;
wobei das erste Entlademittel Folgendes umfasst:
einen ersten NMOS-Transistor mit einem mit der ersten Isolationssteuerleitung verbundenen Drain und einem mit der ersten Entzerrungssteuerleitung verbundenen Gate; und
einen zweiten NMOS-Transistor mit einem mit der Source des ersten NMOS-Transistors verbundenen Drain, einem mit der komplementären Leitung der zweiten Entzerrungssteuerleitung verbundenen Gate und einer mit Masse verbundenen Source.

7. Halbleiterspeicherbauelement nach Anspruch 5, wobei das zweite Entladungsmittel (NB) ein NMOS-Transistor mit einem mit der zweiten Isolationssteuerleitung verbundenen Drain, einem mit der komplementären Leitung der zweiten Isolationssteuerleitung verbundenen Gate und einer mit Masse verbundenen Source ist.

8. Halbleiterspeicherbauelement nach Anspruch 5, wobei das zweite Entlademittel (NB) Folgendes umfasst:
einen ersten NMOS-Transistor mit einem mit der zweiten Isolationssteuerleitung verbundenen Drain und einem mit der zweiten Entzerrungssteuerleitung verbundenen Gate; und
einen zweiten NMOS-Transistor mit einem mit der Source des, ersten NMOS-Transistors verbundenen Drain, einem mit der komplementären Leitung der ersten Entzerrungssteuerleitung verbundenen Gate und einer mit Masse verbundenen Source.

9. Halbleiterspeicherbauelement nach einem der Ansprüche 5 bis 8, das ferner Folgendes umfasst:
ein drittes Entlademittel (NC), das zwischen der ersten Entzerrungssteuerleitung und Masse geschaltet ist, um die erste Entzerrungssteuerleitung schneller zu entladen; und
ein viertes Entlademittel (ND), das zwischen der zweiten Entzerrungssteuerleitung und Masse geschaltet ist, um die zweite Entzerrungssteuerleitung schneller zu entladen.

10. Halbleiterspeicherbauelement nach Anspruch 9, wobei das dritte Entlademittel (NC) ein NMOS-Transistor mit einem mit der ersten Entzerrungssteuerleitung verbundenen Drain, einem mit der komplementären Leitung der ersten Entzerrungssteuerleitung verbundenen Gate und einer mit Masse verbundenen Source ist.

11. Halbleiterspeicherbauelement nach Anspruch 9 oder 10, wobei das vierte Entlademittel (ND) ein NMOS-Transistor mit einem mit der zweiten Entzerrungssteuerleitung verbundenen Drain, einem mit der komplementären Leitung der zweiten Entzerrungssteuerleitung verbundenen Gate und einer mit Masse verbundenen Source ist.

12. Halbleiterspeicherbauelement, das Folgendes umfasst:
mehrere Speicherzellenarrays jeweils mit einem Paar Bitleitungen (BLi, *B̅L̅i̅,* BLj, *B̅L̅j̅*) und mehreren mit dem Paar Bitleitungen verbundenen Speicherzellen;
einen Isolationssteuersignalgenerator (51) zum Erzeugen eines Isolationssteuersignals auf einer Isolationssteuerleitung;
mehrere Leseverstärkerblöcke (33) jeweils auf der linken und rechten Seite der Speicherzellenarrays in einer Spaltenrichtung, jeweils mit einem Paar Lesebitleitungen (SBLi, *S̅B̅L̅i̅),* einer Schalteinheit zum Verbinden des Bitleitungspaares mit dem Lesebitleitungspaar als Reaktion auf das genannte über die genannte Isolationssteuerleitung gesendete Isolationssteuersignal, einen Entzerrer (200, 208) zum Entzerren des Bitleitungspaares als Reaktion auf ein über eine Entzerrungssteuerleitung gesendetes Entzerrungssignal, und einen Leseverstärker (204) zum Erfassen und Verstärken der Spannungsdifferenz zwischen dem Paar Erfassungsbitleitungen; und
mehrere Konjunktionsregionen (27a, 27b) jeweils am oberen und unteren Ende der Leseverstärkungsblöcke (23) in einer Wortleitungsrichtung;
**gekennzeichnet durch** ein erstes Entlademittel (NA), das zwischen der Isolationssteuerleitung und Masse geschaltet ist, um die in den jeweiligen Konjuktionsregionen enthaltene Isolationssteuerleitung rascher zu entladen, wobei das erste Entlademittel von dem über die komplementäre Leitung der Isolationssteuerleitung gesendeten invertierten Isolationssteuersignal gesteuert wird.

13. Halbleiterspeicherbauelement nach Anspruch 12, wobei das erste Entlademittel (NA) ein NMOS-Transistor mit einem mit der Isolationssteuerleitung verbundenen Drain, einem mit der komplementären Leitung der Isolationssteuerleitung verbundenen Gate und einer mit Masse verbundenen Source ist.

14. Halbleiterspeicherbauelement nach Anspruch 12 oder 13, das ferner ein zweites Entlademittel (NB) umfasst, das zwischen der Entzerrungssteuerleitung und Masse geschaltet ist, um die Entzerrungssteuerleitung in jeder Konjunktionsregion rascher zu entladen.

15. Halbleiterspeicherbauelement nach Anspruch 14, wobei das zweite Entlademittel (NB) ein NMOS-Transistor mit einem mit der Entzerrungssteuerleitung verbundenen Drain, einem mit der komplementären Leitung der Entzerrungssteuerleitung verbundenen Gate und einer mit Masse verbundenen Source ist.

## Revendications

1. Mémoire à semi-conducteurs, comprenant :
une paire de lignes binaires (BLi, *B̅L̅i̅*);
une matrice de cellules de mémoire connectée à la paire de lignes binaires ;
une paire de lignes binaires de détection (SBLi, *S̅B̅L̅i̅*) ;
un générateur de signal de commande d'isolation (51) agencé pour générer un signal de commande d'isolation sur une ligne de commande d'isolation (ISi) ;
une unité de commutation (202) pour connecter la paire de lignes binaires (BLi, *B̅L̅i̅)* et la paire de lignes binaires de détection (SBLi, *S̅B̅L̅i̅)* en réponse au signal de commande d'isolation transmis par la ligne de commande d'isolation (ISi) ; un égaliseur (200) pour égaliser la paire de lignes binaires en réponse à un signal d'égalisation (EQi) transmis par une ligne de commande d'égalisation ; et
un amplificateur de détection (204) pour détecter et amplifier la différence de tension entre les deux lignes binaires de détection (SBLi, *S̅B̅L̅i̅*) ;
**caractérisée par** un premier moyen de décharge (NA) connecté entre la ligne de commande d'isolation (ISi) et la terre pour décharger la ligne de commande d'isolation, le générateur de signal de commande d'isolation étant agencé pour générer un signal de commande d'isolation inversé sur une ligne complémentaire (*I̅S̅i̅*) et le premier moyen de décharge (NA) étant commandé par le signal de commande d'isolation inversé transmis par la ligne complémentaire (*I̅S̅i̅*) de la ligne de commande d'isolation.

2. Mémoire à semi-conducteurs selon la revendication 1, dans laquelle le premier moyen de décharge (NA) est un transistor NMOS ayant un drain connecté à la ligne de commande d'isolation (ISi), une porte connectée à la ligne complémentaire de la ligne de commande d'isolation (*I̅S̅i̅*), et une source connectée à la terre.

3. Mémoire à semi-conducteurs selon la revendication 1 ou 2, comprenant en outre un deuxième moyen de décharge (NC) connecté entre la ligne de commande d'égalisation (EQi) et la terre pour décharger plus rapidement la ligne de commande d'égalisation.

4. Mémoire à semi-conducteurs selon la revendication 3, dans laquelle le deuxième moyen de décharge est un transistor NMOS ayant un drain connecté à la ligne de commande d'égalisation, une porte connectée à la ligne complémentaire de la ligne de commande d'égalisation, et une source connectée à la terre.

5. Mémoire à semi-conducteurs comprenant :
des première et deuxième paires de lignes binaires (BLi, *B̅L̅i̅ ,* BLj, *B̅L̅j̅ ;*
une première matrice de cellules de mémoire connectée à la première paire de lignes binaires (BLi, *B̅L̅i̅*) ;
une deuxième matrice de cellules de mémoire connectée à la deuxième paire de lignes binaires (BLj, *B̅L̅j̅*) ;
une paire de lignes binaires de détection (SBLi, *S̅B̅L̅i̅*) ; une première unité de commutation (202) pour connecter la première paire de lignes binaires (BLi, *B̅L̅i̅)* et la paire de lignes binaires de détection (SBLi, *S̅B̅L̅i̅)* en réponse au premier signal de commande d'isolation transmis par une première ligne de commande d'isolation (ISi) ;
un premier générateur de signal de commande d'isolation (51) pour générer ledit premier signal de commande d'isolation (ISi) ;
un deuxième générateur de signal de commande d'isolation (52) pour générer un deuxième signal de commande d'isolation (ISj) ;
une deuxième unité de commutation (206) pour connecter la deuxième paire de lignes binaires (BLj, *B̅L̅j̅*) à la paire de lignes binaires de détection en réponse audit deuxième signal de commande d'isolation transmis par une deuxième ligne de commande d'isolation (ISj) ;
un premier égaliseur (200) pour égaliser la première paire de lignes binaires en réponse à un premier signal d'égalisation transmis par une première ligne de commande d'égalisation ;
un deuxième égaliseur (208) pour égaliser la deuxième paire de lignes binaires en réponse à un deuxième signal d'égalisation transmis par une deuxième ligne de commande d'égalisation ;
un amplificateur de détection (204) pour détecter et amplifier la différence de tension entre les deux lignes binaires de détection ;
un premier moyen de décharge (NA) connecté entre la première ligne de commande d'isolation et la terre pour décharger la première ligne de commande d'isolation pendant l'activation de la deuxième matrice de cellules de mémoire ; et
un deuxième moyen de décharge (NB) connecté entre la deuxième ligne de commande d'isolation et la terre pour décharger la deuxième ligne de commande d'isolation pendant l'activation de la première matrice de cellules de mémoire.

6. Mémoire à semi-conducteurs selon la revendication 5, dans laquelle le premier moyen de décharge (NA) est un transistor NMOS, un drain connecté à la première ligne de commande d'isolation, une porte connectée à la ligne complémentaire de la première ligne de commande d'isolation, et dont la source est connectée à la terre;
dans laquelle le premier moyen de décharge comprend :
un premier transistor NMOS ayant un drain connecté à la première ligne de commande d'isolation, et une porte connectée à la première ligne de commande d'égalisation ; et
un deuxième transistor NMOS ayant un drain connecté à la source du premier transistor NMOS, une porte connectée à la ligne complémentaire de la deuxième ligne de commande d'égalisation, et une source connectée à la terre.

7. Mémoire à semi-conducteurs selon la revendication 5, dans laquelle le deuxième moyen de décharge (NB) est un transistor NMOS, un drain connecté à la deuxième ligne de commande d'isolation, une porte connectée à la ligne complémentaire de la deuxième ligne de commande d'isolation, et une source connectée à la terre.

8. Mémoire à semi-conducteurs selon la revendication 5, dans laquelle le deuxième moyen de décharge (NB) comprend :
un premier transistor NMOS ayant un drain connecté à la deuxième ligne de commande d'isolation,
et une porte connectée à la deuxième ligne de commande d'égalisation ; et
un deuxième transistor NMOS ayant un drain connecté à la source du premier transistor NMOS, une porte connectée à la ligne complémentaire de la première ligne de commande d'égalisation, et une source connectée à la masse.

9. Mémoire à semi-conducteurs selon l'une quelconque des revendications 5 à 8, comprenant en outre :
un troisième moyen de décharge (NC) connecté entre la première ligne de commande d'égalisation et la terre pour décharger plus rapidement la première ligne de commande d'égalisation ; et
un quatrième moyen de décharge (ND) connecté entre la deuxième ligne de commande d'égalisation et la terre pour décharger plus rapidement la deuxième ligne de commande d'égalisation.

10. Mémoire à semi-conducteurs selon la revendication 9, dans laquelle le troisième moyen de décharge (NC) est un transistor NMOS ayant un drain connecté à la première ligne de commande d'égalisation, une porte connectée à la ligne complémentaire de la première ligne de commande d'égalisation, et une source connectée à la terre.

11. Mémoire à semi-conducteurs selon la revendication 9 ou 10, dans laquelle le quatrième moyen de décharge (ND) est un transistor NMOS ayant un drain connecté à la deuxième ligne de commande d'égalisation, une porte connectée à la ligne complémentaire de la deuxième ligne de commande d'égalisation, et une source connectée à la terre.

12. Mémoire à semi-conducteurs, comprenant :
une pluralité de matrices de cellules de mémoire ayant chacune une paire de lignes binaires (BLi, *B̅L̅i̅,* BLj, *B̅L̅j̅)* et une pluralité de cellules de mémoire connectées à la paire de lignes binaires ; un générateur de signal de commande d'isolation (51) agencé pour générer un signal de commande d'isolation sur une ligne de commande d'isolation ;
une pluralité de blocs d'amplification (33) agencés sur les côtés gauche et droit des matrices de cellules de mémoire respectives dans une direction verticale, chacun ayant une paire de lignes binaires de détection (SBLi, *S̅B̅L̅i̅),* une unité de commutation pour connecter la paire de lignes binaires à la paire de lignes binaires de détection en réponse audit signal de commande d'isolation transmis par ladite ligne de commande d'isolation, un égaliseur (200, 208) pour égaliser la paire de lignes binaires en réponse à un signal d'égalisation transmis par une ligne de commande d'égalisation, et un amplificateur de détection (204) pour détecter et amplifier la différence de tension entre les deux lignes binaires de détection ; et
une pluralité de zones de conjonction (27a, 27b) agencées aux extrémités supérieure et inférieure des blocs d'amplification de détection (23) dans une direction horizontale ;
**caractérisée par** le premier moyen de décharge (NA) connecté entre la ligne de commande d'isolation et la terre pour décharger plus rapidement la ligne de commande d'isolation incluse dans les zones de conjonction respectives, le premier moyen de décharge étant commandé par le signal de commande d'isolation inversé transmis par la ligne complémentaire de la ligne de commande d'isolation.

13. Mémoire à semi-conducteurs selon la revendication 12, dans laquelle le premier moyen de décharge (NA) est un transistor NMOS ayant un drain connecté à la ligne de commande d'isolation, une porte connectée à la ligne complémentaire de la ligne de commande d'isolation, et une source connectée à la terre.

14. Mémoire à semi-conducteurs selon la revendication 12 ou 13, comprenant en outre un deuxième moyen de décharge (NB) connecté entre la ligne de commande d'égalisation et la terre pour décharger plus rapidement la ligne de commande d'égalisation dans chaque zone de conjonction.

15. Mémoire à semi-conducteurs selon la revendication 14, dans laquelle le deuxième moyen de décharge (NB) est un transistor NMOS ayant un drain connecté à la ligne de commande d'égalisation, une porte connectée à la ligne complémentaire de la ligne de commande d'égalisation, et une source connectée à la terre.
